# EUROPÄISCHE PATENTSCHRIFT

(11) **EP 0 733 301 B1**
(45) Veröffentlichungstag und Bekanntmachung des Hinweises auf die Patenterteilung: **15.04.1998**
(21) Anmeldenummer: 94904160.2
(22) Anmeldetag: 20.12.1993
(51) Int. Cl.: H05K 5/04, A45C 5/02

(54) **GERÄTEKOFFER**
EQUIPMENT CASE
COFFRE POUR APPAREILS

(43) Veröffentlichungstag der Anmeldung: 25.09.1996
(73) Patentinhaber: Knürr Mechanik für die Elektronik AG, D-81829 München (DE)
(72) Erfinder: RICKINGER, Thomas, D-94424 Arnstorf (DE); REGIRT, Walter, D-84381 Johanniskirchen (DE); FLAMME, Hans, D-82008 Unterhaching (DE); SCHAERER, Erwin, D-89129 Langenau (DE); HÜTTINGER, Wolfgang, D-81673 München (DE)
(74) Vertreter: Heim, Hans-Karl, Dipl.-Ing.
(86) Internationale Anmeldenummer: EP9303619
(87) Internationale Veröffentlichungsnummer: WO9517804

(56) Entgegenhaltungen:
- DE-A- 2 215 061
- DE-A- 2 732 139
- DE-U- 9 307 502

## Beschreibung

Die Erfindung betrifft einen Gerätekoffer gemäß Oberbegriff des Anspruchs 1.

Derartige Gerätekoffer, die als tragbare Schutzgehäuse für elektrische und elektronische Geräte dienen, sind bekannt und beispielsweise in der EP 0 327 809 A2 beschrieben.

Da die Geräte meist in militärischen und Forschungsbereichen eingesetzt werden und sehr hohen mechanischen, Temperatur- und sonstigen extremen Umwelteinflüssen standhalten müssen, weisen die quader- oder kastenförmigen Gerätekoffer ein selbsttragendes, metallisches Gehäuse mit einem vibrationsfesten Gehäusemantel, einem Frontdeckel und einer Rückseite auf. Die Rückseite kann ebenfalls als Deckel ausgebildet sein. Innerhalb des Gehäusemantels und im Abstand zu diesem ist ein Innenrahmen mit einem üblicherweise genormten Aufnahmeraum für die Geräte und Baugruppen angeordnet, der über schwingungsdämpfende Elemente befestigt ist. Bei dem in der EP 0 327 809 A2 beschriebenen Schutzgehäuse ist der Innenrahmen beispielsweise mittels acht Schwingungsdämpfern in den Eckbereichen des Gehäusemantels aufgehängt.

Ein Nachteil der bisher bekannten Gerätekoffer ist deren relativ aufwendige Fertigung. Beispielsweise werden die vier Plattenteile des Gehäusemantels in der Regel zusammengeschweißt. Um eine IP-Abdichtung und eine elektrische Abschirmung (HF-Dichtung) realisieren zu können, sind zusätzlich an den deckelseitigen Endbereichen des Gehäusemantels ebenso wie am Innenrahmen Flansche oder Randprofile zur Aufnahme von umlaufenden Dichtungen vorgesehen. Die Fertigung ist aufgrund der vielen Einzelteile, die zudem eine besonders übersichtliche Lagerhaltung erforderlich macht, relativ aufwendig und kostenintensiv. Außerdem können die zahlreichen Bauteile und Fertigungsschritte Fehlerquellen darstellen, die sich negativ auf die Schutzfunktion des Gerätekoffers auswirken können.

Der Erfindung liegt die **Aufgabe** zugrunde, einen Gerätekoffer zu schaffen, dessen konstruktiver Aufbau eine hohe Funktionalität gewährleistet und zugleich eine einfache, kostengünstige Herstellung ermöglicht.

Erfindungsgemäß wird die Aufgabe durch die kennzeichnenden Merkmale des Anspruchs 1 gelöst. Vorteilhafte und zweckmäßige Ausgestaltungen sind in den Unteransprüchen und in der Figurenbeschreibung enthalten.

Ein Grundgedanke der Erfindung ist es, durch eine integrale Bauweise eine Funktionsvereinigung zu erreichen, so daß die Anzahl der Einzelteile und der Fertigungsschritte reduziert und damit die Fertigung des Gerätekoffers effektiver gestaltet werden kann. Neben den Fertigungs- und Kostenvorteilen wird eine hohe Stabilität und eine Gebrauchswerterhöhung des Gerätekoffers erreicht, die insbesondere in einem verbesserten Design, einer geschützten Anbringung von Verschlüssen, Griffen und dergleichen und in einer besonders großen Zubehör-Adaption begründet ist.

Erfindungsgemäß ist der Gehäusemantel des metallischen, selbsttragenden Gehäuses, das in der Regel quader- oder kastenförmig ausgebildet ist, aus einem einzigen Teil gefertigt, so daß eine Reduzierung der Bauteile und der Fertigungsschritte möglich ist.

Das als einstückiges Flachmaterial ausgebildete Zuschnitt-Teil des Gehäusemantels wird einem Biegeverfahren unterworfen. Hierbei werden eine Grund- und Deckfläche, zwei vertikale Seitenteile und zwischen diesen Gehäusemantelbereichen liegende Eckschrägen, bevorzugt als 45-Grad-Abschrägungen, ausgebildet.

Vorteilhafterweise ist nur eine einzige Verbindung, beispielsweise eine Schweißnaht, erforderlich, um nach dem Abbiegeprozeß den einstückigen Gehäusemantel zu verbinden. Ein weiterer Vorteil ist eine unbehinderte Stapelung und ein störungsfreier Transport der erfindungsgemäßen Gerätekoffer, da sowohl im Gehäusemantel als auch in der Front- und Rückseite, die üblicherweise als Deckel ausgebildet sind, vertiefte Bereiche zur Aufnahme von Tragegriffen, Verschlüssen, Verriegelungen und dergleichen vorgesehen sind. Diese Bereiche sowie Prägungen werden in einer kostengünstigen Weise am einzigen Zuschnitt-Teil und vor dem Abbiegevorgang hergestellt.

Die 45-Grad-Eckschrägen des Gehäusemantels tragen zu einem verbesserten Design des erfindungsgemäßen Gerätekoffers bei und erhöhen dessen Funktionalität, da in den Eckschrägen Befestigungen vorgesehen werden können, ohne daß der eigentliche Stapelbereich des Gerätekoffers beeinträchtigt wird.

Der Gehäusemantel ist mit einem umlaufenden front- und rückseitigen Hohlprofil versehen, das ebenfalls in einem Biegeprozeß durch 45-, 80- und 90-Grad-Abwinkelungen ausgebildet werden kann. Dieses Hohlprofil unterstützt in besonders vorteilhafter Weise die integrale Bauweise des erfindungsgemäßen Gerätekoffers. Da die vier Eckschrägen aufgrund von verschweißbaren Ausnehmungen im einzigen Zuschnitt-Teil ebenfalls mit dem Gehäusemantel-Hohlprofil versehen sind, ist eine umlaufende, mit einer Deckelkante zusammenwirkende IP- und HF-Abdichtung in einer besonders einfachen Weise möglich. Beispielsweise kann an einem Befestigungssteg des Hohlprofils eine Dichtmanschette angebracht werden.

Bevorzugt ist das frontseitige und das spiegelbildlich ausgebildete rückseitige Hohlprofil mit einem deckelseitigen, die Festigkeit erhöhenden Kastenprofil versehen. Dieses Kastenprofil weist eine dachförmige Dichtkante auf, an der bei geschlossenem Deckel eine deckelseitige Nut des Deckels nahezu anliegt. Außerdem ist am Hohlprofil eine Schließkante für eine Deckelverriegelung ausgebildet und es besteht die Möglichkeit, ein Kofferscharnier zu befestigen.

Die Ausbildung des Gehäuse- bzw. Koffermantels aus einem einstückigen, metallischen Flachmaterial ist ein wesentlicher Erfindungsgedanke.

Diese Herstellungsweise ist durch den Zuschnitt des Flachmaterials möglich. Hierzu sind im Bereich der Eckschrägen rhombusartige Ausstanzungen beidseitig zu einer Zunge vorgesehen. Die Tiefe der Ausstanzung im Flachmaterial reicht hierbei von der jeweiligen Randkante des Flachmaterials bis in einen nach innen hin orientierten Bereich, der der ersten äußeren Abkantung des Hohlprofils entspricht. Die Zunge hat dabei einen inneren Schmalbereich, der durch beidseitige rhombusartigen Ausnehmungen begrenzt ist, welche zum Randbereich des Flachmaterials in einer dünnen Schnittlinie bzw. einem dünnen Schnittkanal auslaufen. Direkt an der Randkante ist eine verbreiternde Abschrägung des Schnittkanals vorgesehen. Die Ausstanzungen und der Schnittkanal haben daher etwa die Form einer "Speerspitze", wobei in der Symmetrielinie zweier nebeneinander vorgesehener Ausstanzungen die die Eckschräge bildende Zunge im Flachmaterial vorgesehen ist.

Die Eckschrägen des Gehäusemantels stellen nicht nur ein vorteilhaftes Designmerkmal dar, sondern bieten auch die Möglichkeit der Wandbefestigung und der Verbindung aneinander gereihter Gehäuse. Außerdem können Kranösen und ein Stativ angebracht und Boden- und Rollenbefestigungen in diesen Bereichen vorgenommen werden.

Die Eckschrägen dienen darüber hinaus der Aufhängung des vibrationsfesten Innenrahmens, wozu vorteilhafterweise jeweils eine Aufnahmeschiene und ein Schwingmetall als schwingungsdämpfendes Element in den Eckschrägen angeordnet werden. Dabei wirken diese Aufnahmeschienen und die Schwingmetalle jeweils bevorzugt mit einem Tiefenholm zusammen, durch den die frontseitigen und rückseitigen Vertikal- und Horizontalholme zum Innenrahmen verbunden sind.

Zweckmäßigerweise bestehen die Vertikal- und Horizontalholme des Innenrahmens aus einem einheitlichen Rahmenprofil mit einem äußeren Rahmensteg und zwei T-Nuten, die variable Befestigungsmöglichkeiten bieten. Beispielsweise können an der inneren, zum Aufnahmeraum offenen T-Nut Teleskopschienen, Einschubschienen und dergleichen befestigt werden.

Die Tiefenholme, die die Festigkeit des Rahmens wesentlich beeinflussen, können mit Sicken versehen sein. Sie stellen die Montageebene zum Einschieben des Innenrahmens dar, wobei zwei rechtwinklig zueinander angeordnete Befestigungsflansche mit ihren front- und rückseitigen Bereichen an den zugehörigen Vertikal- und Horizontalholmen anliegen. Ein die Befestigungsflansche verbindender, schräger Eckverbinder weist front- und rückseitige, überstehende Abdeckbereiche für die Stirnflächen der Vertikal- und Horizontalholme auf.

Die Aufnahmeschiene für das Schwingmetall, die zwei rechtwinklig zueinander angeordnete Seitenflächen und ein zentrales Schienenteil aufweist, wird mit dem Gehäusemantel durch Kleberverbindungen oder Gewindebolzen oder auch durch Verschweißen verbunden. Die Aufnahmeschiene erhöht die Stabilität des Gerätekoffers, so daß dieser auch ohne Innenrahmen verwendbar ist. In diesem Falle können in den Seitenflächen ausgebildete Befestigungselemente, wie Nuten, insbesondere T-Nuten, oder Langlöcher, in besonders vorteilhafter Weise zur Befestigung von diversen Bauteilen oder Schienen und dergleichen dienen.

Durch die konstruktive Ausbildung der Aufnahmeschiene ist auch eine leichte Montage der Schwingmetalle möglich, da die Befestigungspunkte variabel gestaltet werden können. Im zentralen, gegebenenfalls hohlen und im Querschnitt rechteckigen oder auch U-förmigen Schienenteil können Ausnehmungen aber auch Befestigungsbolzen, angebracht sein, deren Zahl und Lage, insbesondere bei Verwendung von Federmuttern variiert werden kann.

Die Schwingmetalle befinden sich jeweils zwischen einer Aufnahmeschiene und einem Tiefenholm. Sie bestehen in einer zweckmäßigen Ausgestaltung aus zwei Flachstahlelementen, wovon ein äußeres Flachstahlelement breiter als das innere Flachstahlelement ausgebildet ist und Befestigungsbereiche aufweist, die mit den Befestigungsöffnungen bzw. Befestigungselementen der Aufnahmeschiene zusammenwirken. Zwischen beiden Flachstahlelementen ist ein Elastomer-Werkstoff, insbesondere M-förmig angeordnet.

Der Aufnahmeraum des Gerätekoffers ist von der Frontseite und gegebenenfalls auch von der Rückseite zugänglich, die bevorzugt mit einem Front- bzw. Rückseitendeckel IP- und HF-dicht abschließbar sind.

Die Deckel bestehen prinzipiell aus zwei Teilen. Eine Dekkelplatine ist mit Prägungen und Vertiefungen für eine geschützte Anbringung von Verschlüssen, Ventilen, Anschlüssen usw. versehen und weist eine hohe Festigkeit auf. Eine umlaufende Dichtkante, die an die Deckelplatine angeschweißt sein kann, besteht aus einem Verbindungssteg mit einer zum Aufnahmeraum gerichteten T-Nut und einer zum Hohlprofil des Gehäusemantels gerichteten U-Nut, die dichtend am Hohlprofil des Gehäusemantels anliegt.

Die Erfindung wird nachstehend anhand einer schematischen Zeichnung weiter beschrieben; in dieser zeigen:
- Fig. 1: eine perspektische Ansicht einer bevorzugten Ausführungsform des erfindungsgemäßen Gerätekoffers;
- Fig. 2: eine schematische Draufsicht auf die Frontseite des Gehäusemantels gemäß Fig. 1;
- Fig. 3: einen Gehäusemantel-Zuschnitt vor dem Biegeprozeß;
- Fig. 4: eine Innenansicht eines Eckbereiches eines Gehäusemantels gemäß Fig. 1 mit einer Eckschräge;
- Fig. 5: einen Vertikalschnitt durch die Deckfläche des Gehäusemantels mit einem front- und rückseitigen Hohlprofil;
- Fig. 6: eine perspektivische Ansicht eines Innenrahmens;
- Fig. 7: eine perspektivische Ansicht eines Tiefenholms des Innenrahmens;
- Fig. 8: einen Querschnitt eines Rahmenprofils des Innenrahmens;
- Fig. 9: eine perspektivische Teilansicht einer ersten Ausführungsform einer Aufnahmeschiene;
- Fig. 10: eine frontseitige Ansicht einer Aufnahmeschiene gem. Fig. 9;
- Fig. 11: einen Seitenansicht eines Schwingmetalls;
- Fig. 12: eine Ansicht des Schwingmetalls nach Pfeil A gemäß Fig. 11;
- Fig. 13: einen Querschnitt einer als Strangpreßprofil ausgebildeten Dichtkante eines Deckels;
- Fig. 14: eine perspektivische Teilansicht einer weiteren Ausführungsform einer Aufnahmeschiene und
- Fig. 15: eine frontseitige Ansicht einer Aufnahmeschiene gem. Fig. 14.

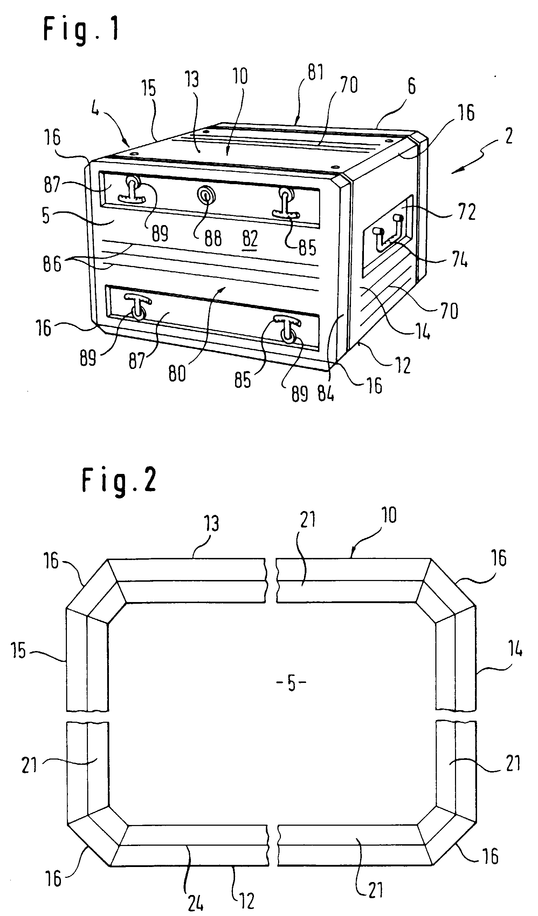

Eine in Fig. 1 dargestellte bevorzugte Ausführungsform eines erfindungsgemäßen Gerätekoffers 2 weist ein Gehäuse 4 mit einem Gehäusemantel 10 und jeweils einen die Front- und Rückseite 5,6 verschließbaren Frontdeckel 80 und Rückseitendeckel 81 auf.

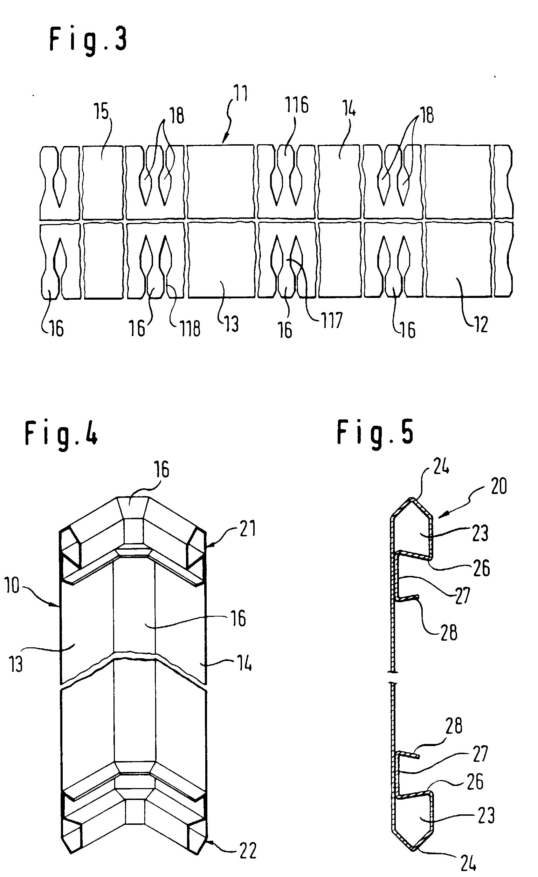

Der Gehäusemantel 10 wird aus einem einzigen Zuschnitt-Teil 11 gemäß Fig. 3, das ein einstückiges, metallisches Flachmaterial ist, in einem Biegeprozeß hergestellt. Hierbei werden vertikale Seitenflächen oder -teile 14,15, eine Deckfläche 13 und eine Grundfläche 12 sowie die 45°-Eckschrägen 16 und darüber hinaus ein frontseitiges und rückseitiges Hohlprofil 21,22 (Fig. 2 und 4) ausgebildet. Das Hohlprofil 20 kann in den vier Eckschrägen 16 des erfindungsgemäßen Gehäusemantels 10 (Fig. 2) aufgrund der im einzigen Zuschnitt-Teil 11 (Fig. 3) ausgebildeten rhombenartigen Ausnehmungen 18 durch Verschweißen hergestellt werden. Das Hohlprofil 20 des Gehäusemantels 10 besteht aus einem frontseitigen Hohlprofil 21 und einem spiegelbildlich zu diesem ausgebildeten rückseitigen Hohlprofil 22. Durch 45-,80- und 90-Grad-Abbiegungen des einzigen Teils 11 des Gehäusemantels 10 sind ein Kastenprofil 23 (Fig. 5) mit einer dachförmigen, zum Front- und Rückseitendeckel 80,81 gerichteten Dichtkante 24 und mit einer Schließkante 26 sowie ein am Gehäusemantel 10 anliegender Stützsteg 27 und ein endseitiger Befestigungssteg 28, beispielsweise für eine Dichtmanschette, gebildet.

Der Zuschnitt 11 des Flachmaterials für den Koffermantel 2 weist im Bereich der Eckschrägen 16 eine Zunge 116 auf. Diese oben und unten im Flachmaterial vorgesehene Zunge 116 weist zur Mitte des Flachmaterials einen schmäleren Steg 117 auf, der beidseitig durch die rhombenartigen Ausstanzungen 18 begrenzt ist.

Die Ausstanzung 18 reicht hierbei von der Randkante des Flachmaterials 11 als schmale Schnittlinie 118 in den zur Mitte gerichteten rhombenartigen Bereich.

Hinter die Schließkante 26 greift bei einem mit einem Dekkel 80 geschlossenen Gerätekoffer 2 ein L-förmiger, drehbarer und mit einem Griff 85 betätigbarer Hebel.

Aus Fig. 1 gehen außerdem die im einzigen Teil 11 des metallischen Flachmaterial-Zuschnitts gemäß Fig. 3 nicht dargestellten, aber vor dem Biegeprozeß eingeformten Prägungen 70 und vertiefte Bereiche 72, beispielsweise für Handgriffe 74, hervor, die zusammen mit den Eckschrägen zu einem besonders ästhetischen Gesamteindruck des Gerätekoffers 2 beitragen.

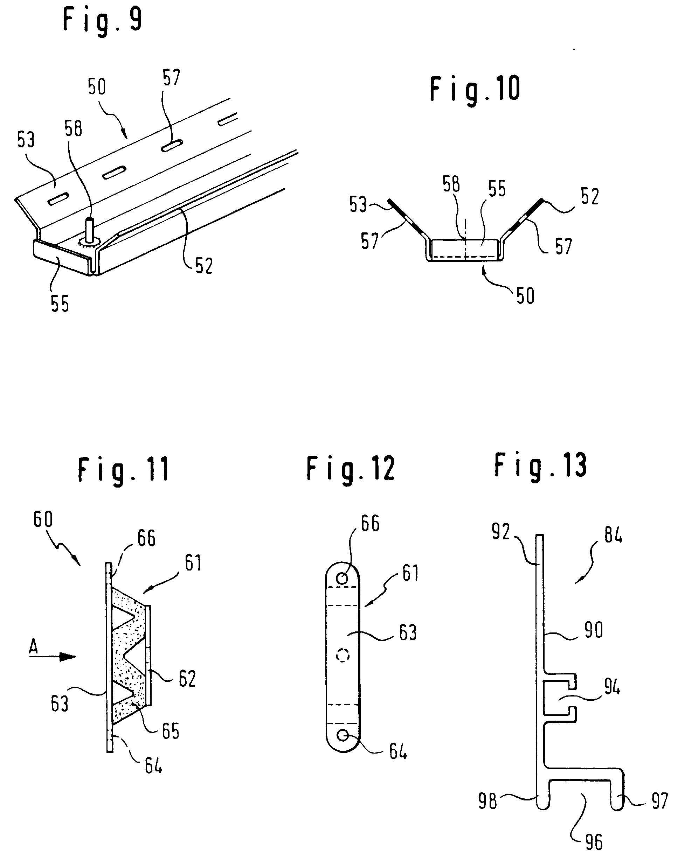

Der Gerätekoffer 2 gemäß Fig. 1 ist mit einem gleich ausgebildeten Front- und Rückseitendeckel 80,81 verschließbar, wobei ein Deckel aus einer Deckelplatine 82 und einer Dichtkante 84 besteht. Die Dichtkante 84 ist an die Deckelplatine 82 bevorzugt angeschweißt und besteht aus einem Strangpreßprofil, das im Zusammenhang mit der Fig. 13 beschrieben wird. Die Deckelplatine 82 ist von hoher Festigkeit und weist Versteifungsprägungen 86 sowie Vertiefungen 87 für Verriegelungen 89 mit schwenkbaren Griffen 85 und für Anschlüsse beispielsweise ein Ventil 88 auf.

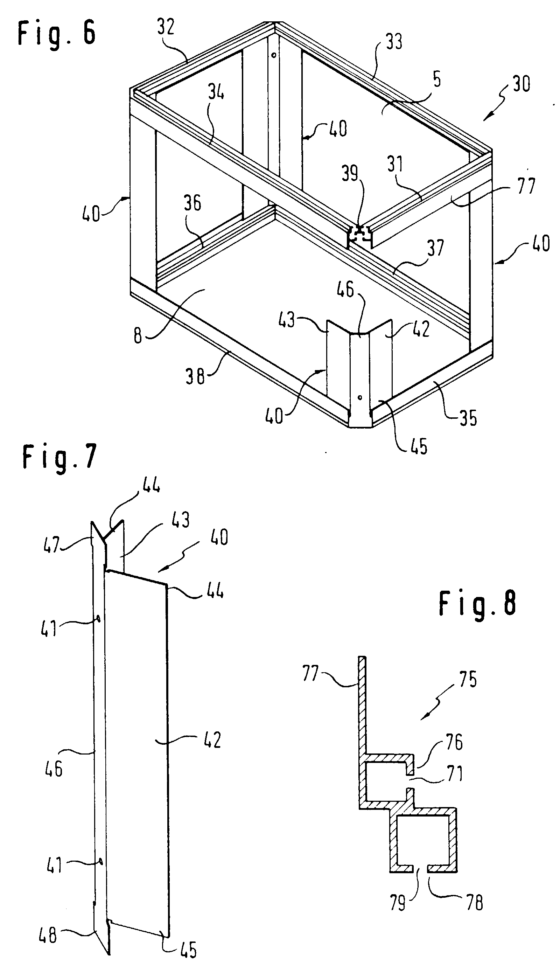

In Fig. 6 ist ein mit der Frontseite 5 nach oben gerichteter Innenrahmen 30 dargestellt, der aus frontseitigen Vertikal- und Horizontalholmen 31,32; 33,34 und rückseitigen Vertikal- und Horizontalholem 35,36; 37,38 sowie aus vier, die Vertikal- und Horizontalholme verbindenden Tiefenholmen 40 besteht. Der Innenrahmen umschließt einen genormten Aufnahmeraum 8, in dem Geräte und Baugruppen IP- und HF-abgedichtet aufgenommen werden können.

Ein Tiefenholm 40, der die Stabilität des Innenrahmens 30 bestimmt, ist in einer perspektivischen Ansicht in Fig. 7 dargestellt. Der Tiefenholm 40 ist mit einem front- und rückseitigen Bereich 44,45 an zwei seitlichen Befestigungsflanschen 42,43 in die zugehörigen front- und rückseitigen Vertikal- und Horizontalholme, beispielsweise in die Vertikalholme 31,35 und in die Horizontalholme 34,38 einschiebbar, wobei die Stirnflächen 39 der Vertikal- und Horizontalholme von überstehenden Abdeckbereichen 47,48 eines schräg zwischen den Befestigungsflanschen 42,43 angeordneten Eckverbinders 46 abgedeckt werden. Der Eckverbinder 46 weist Befestigungsöffnungen 41 auf, die zur Halterung der Tiefenholme 40 bzw. des Innenrahmens 30 an einem Schwingmetall 61 als einem schwingungsdämpfenden Element 60 bzw. an einer Aufnahmeschiene 50 dienen.

In einer besonders kostengünstigen Weise sind die Vertikal- und Horizontalholme 31 bis 38 des Innenrahmens 30 aus einem einheitlichen Profil 75 gefertigt, das in Fig. 8 im Querschnitt dargestellt ist. An einem zum Gehäusemantel 10 weisenden Rahmensteg 77 ist eine innere T-Nut 76 mit einem zum Aufnahmeraum 8 gerichteten Nutschlitz 71, beispielsweise zur Aufnahme von Teleskopschienen und ähnlichem ausgebildet. Nach einer Abwinklung des Rahmenstegs 77 ist eine weitere, äußere T-Nut 78 vorhanden, deren Nutschlitz 79 zur Front- bzw. Rückseite 5,6 weist.

Die Fig. 9 zeigt eine in jede Eckschräge 16 des Gehäusemantels 10 einzuklebende oder zu verschweißende erste Variante einer Aufnahmeschiene 50 für ein als schwingungsdämpfendes Element 60 dienendes Schwingmetall 61. Die Aufnahmeschiene 50 verläuft mit einem Schienenteil 55 zwischen dem frontseitigen Hohlprofil 21 und dem rückseitigen Hohlprofil 22 des Gehäusemantels 20. Das Schienenteil 55 ist analog zu den erfindungsgemäßen Eckschrägen 16 des Gehäusemantels 10 als eine 45°-Abschrägung zwischen zwei rechtwinklig zueinander angeordneten Seitenflächen 52,53 angeordnet. Das Schienenteil 55 ist im Querschnitt rechteckig und hohl ausgebildet und ist bei dieser Ausführungsform mit mittig angeordneten Befestigungselementen 58, beispielsweise Einpreßbolzen, versehen. In den Seitenflächen 52,53 sind Langlöcher 57 vorhanden, die insbesondere unter Verwendung von Federmuttern der Befestigung diverser Einbauteile, wie Querverbindungen dienen können, wenn der Gerätekoffer ohne Innenrahmen 30 verwendet wird.

Die Fig. 10 zeigt einen schematischen Querschnitt der Aufnahmeschiene 50, wobei gleiche Merkmale mit identischen Bezugszeichen versehen sind.

Das Schwingmetall (Fig. 11 und Fig. 12) besteht aus zwei Flachstahlelementen 62,63, die durch einen M-förmigen Elastomer-Werkstoff 65 verbunden sind. Das äußere Flachstahlelement 63 liegt am Schienenteil 55 der Aufnahmeschiene 50 an und wird beispielsweise an dessen Befestigungsbolzen 58 über Befestigungsöffnungen 64, 66 gehalten. Das innere Flachstahlelement 62 liegt dann am Tiefenholm 40 des Innenrahmens 30 an.

In Fig. 13 ist eine Dichtkante 84 eines Front- oder Rückseitendeckels 80,81 in schematischer Weise dargestellt. Ein Strangpreßprofil 90 mit einem an der Deckelplatine 82 beispielsweise anschweißbaren Verbindungssteg 92 ist mit einer T-Nut 94 und einer U-Nut 96 versehen. Die T-Nut 94 dient zur Befestigung zusätzlicher Elemente und Bauteile. Die U-Nut 96 liegt mit ihren vertikalen Schenkeln 97,98 am Hohlprofil 20 des Gehäusemantels 10 an und sichert eine effektive Abdichtung der im Gerätekoffer angeordneten Geräte und Baugruppen.

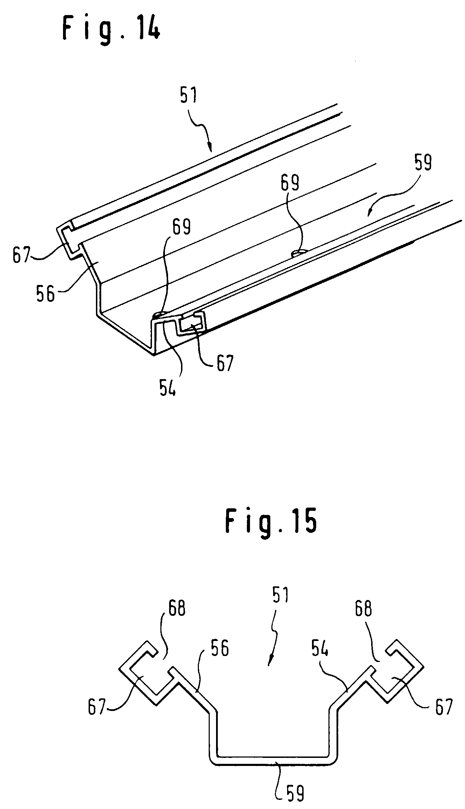

In Fig. 14 ist eine weitere, bevorzugte Ausführungsform einer Aufnahmeschiene 51 dargestellt. Zwei rechtwinklig zueinander angeordnete Seitenflächen 54, 56 sind durch ein zentrales, in der Eckschräge 16 des Gerätekoffers 2 zu befestigendes Schienenteil 59 verbunden. Das zentrale Schienenteil 59 ist im Querschnitt U-förmig ausgebildet und mit Befestigungsöffnungen 69 versehen. Zur variablen Befestigung diverser Einbauteile, insbesondere dann, wenn der Gerätekoffer ohne Innenrahmen verwendet werden soll, ist jede Seitenfläche 54, 56 mit einer in Längsrichtung verlaufenden T-Nut 67 versehen. Die T-Nuten 67 sind spiegelbildlich mit zueinander gerichtetem Nutschlitz 68 an der Aufnahmeschiene 51 ausgebildet (Fig. 15).

## Patentansprüche

1. Gerätekoffer mit einem metallischen Gehäuse, welches einen quaderförmigen Gehäusemantel sowie eine Frontseite und eine Rückseite aufweist, wobei zumindest die Frontseite als Deckel ausgebildet ist, und mit einem Innenrahmen, der über schwingungsdämpfende Elemente auf Abstand am Gehäusemantel befestigt ist und einen Aufnahmeraum für Geräte und Baugruppen umschließt,
dadurch **gekennzeichnet**,
daß der Gehäusemantel (10) mit Grundfläche (12), Deckfläche (13) und Seitenflächen (14, 15) aus einem einstückigen, metallischen Flachmaterial (11) hergestellt ist und jeweils zwischen den Seitenflächen (14, 15) und der angrenzenden Deckfläche (12) bzw. Grundfläche (13) eine Eckschräge (16) zur schwingungsdämpfenden Aufnahme des Innenrahmens (30) ausgebildet ist und daß der Gehäusemantel (10) an der Frontseite (5) und Rückseite (6) ein aus dem einstückigen Flachmaterial (11) gebildetes, umlaufendes frontseitiges (21) und rückseitiges (22) Hohlprofil aufweist.

2. Gerätekoffer nach Anspruch 1,
dadurch **gekennzeichnet**,
daß jede Eckschräge (16) als eine schmale, 45°-Abbiegung der Seitenflächen (14, 15), Deckfläche (13) und Grundfläche (12) des Gehäusemantels (10) ausgebildet ist, daß das frontseitige (21) und rückseitige (22) Hohlprofil des Gehäusemantels (10) in den Eckschrägen (16) durch verschweißbare Ausnehmungen (18) in dem Flachmaterial (11) gebildet ist und daß zur Befestigung des Innenrahmens (30) zwischen dem frontseitigen (21) und rückseitigen (22) Hohlprofil der Eckschrägen (16) jeweils eine Aufnahmeschiene (50) für ein schwingungsdämpfendes Element (60) und für den Innenrahmen (30) angeordnet ist.

3. Gerätekoffer nach Anspruch 2,
dadurch **gekennzeichnet**,
daß die Seitenflächen (14, 15), die Deckfläche (13) und die Grundfläche (12) des abzubiegenden Gehäusemantels (10) vorgefertigte Prägungen (70) und vertiefte Bereiche (72) zur Anordnung von Griffen (74), Anschluß- und Transportelementen sowie Verschlußbereiche aufweisen.

4. Gerätekoffer nach Anspruch 2,
dadurch **gekennzeichnet**,
daß das frontseitige (21) und rückseitige (22) Hohlprofil des Gehäusemantels (10) durch Mehrfach-Abbiegungen des zugeschnittenen Flachmaterials (11) gebildet ist und jeweils ein Kastenprofil (23) mit einer zur Frontseite (5) und zur Rückseite (6) gerichteten dachförmigen Dichtkante (24) und einer diametral angeordneten Schließkante (26) für eine Deckelverriegelung aufweist und daß das Kastenprofil (23) nach innen zu einem am Gehäusemantel (10) anliegenden Stützsteg (27) und einem endseitigen, nahezu rechtwinklig zum Stützsteg (27) abstehenden Befestigungssteg (28), insbesondere für ein Dichtungselement, abgebogen ist.

5. Gerätekoffer nach Anspruch 1,
dadurch **gekennzeichnet**,
daß der Innenrahmen (30) aus frontseitig und rückseitig angeordneten Vertikalholmen (31, 32; 35, 36) und Horizontalholmen (33, 34; 37, 38) gebildet ist, die ein einheitliches Rahmenprofil (75) aufweisen und über Tiefenholme (40) miteinander verbunden sind.

6. Gerätekoffer nach Anspruch 5,
dadurch **gekennzeichnet**,
daß das Rahmenprofil (75) der Vertikalholme und Horizontalholme (31 bis 38) einen zum Gehäusemantel (10) gerichteten Rahmensteg (77) mit einer inneren und äußeren T-Nut (76,78) aufweist, wobei der Nutschlitz (71) der inneren T-Nut (76) zum Aufnahmeraum (8) und der Nutschlitz (79) der äußeren T-Nut (78) zur Frontseite (5) oder zur Rückseite (6) gerichtet ist.

7. Gerätekoffer nach Anspruch 5,
dadurch **gekennzeichnet**,
daß jeder Tiefenholm (40) zwei rechtwinklig zueinander angeordnete Befestigungsflansche (42, 43) aufweist, deren frontseitigen (44) und rückseitigen (45) Bereiche an den zugehörigen Vertikalholmen und Horizontalholmen (31, 35; 33, 37) fixierbar sind, und daß die Befestigungsflansche (42, 43) über einen Eckverbinder (46) miteinander verbunden sind, wobei der Eckverbinder (46) in einer 45-Grad-Schräge angeordnet ist und einen überstehenden frontseitigen (47) und rückseitigen (48) Abdeckbereich für die Stirnflächen (39) der Vertikalholme und Horizontalholme (31 bis 38) des Innenrahmens (30) aufweist.

8. Gerätekoffer nach Anspruch 2,
dadurch **gekennzeichnet**,
daß die in den Eckschrägen (16) des Gehäusemantels (10) fixierbaren Aufnahmeschienen (50; 51) zwei rechtwinklig zueinander angeordnete Seitenflächen (52, 53; 54, 56) und ein komplementär zu den Eckschrägen (16) ausgebildetes, zentrales Schienenteil (55; 59) aufweisen, die mit Befestigungsbereichen (57, 58; 67, 69) versehen sind.

9. Gerätekoffer nach Anspruch 8,
dadurch **gekennzeichnet**,
daß die Aufnahmeschienen (50; 51) durch eine Klebeverbindung in den Eckschrägen (16) des Gehäusemantels (10) gehalten sind.

10. Gerätekoffer nach Anspruch 8,
dadurch **gekennzeichnet**,
daß die Befestigungsbereiche (57) der Seitenflächen (52, 53) einer Aufnahmeschiene (50) Langlöcher sind und daß das zentrale Schienenteil (55) ein rechteckiges Hohlprofil (55) ist, dessen Befestigungsbereiche (58) Befestigungsbolzen (58) sind.

11. Gerätekoffer nach Anspruch 8,
dadurch **gekennzeichnet**,
daß die Befestigungsbereiche (67) der Seitenflächen (54, 56) einer Aufnahmeschiene (51) als T-Nut (67) ausgebildet sind und daß das zentrale Schienenteil (59) ein U-förmiges Hohlprofil (59) aufweist, dessen Befestigungsbereiche (69) Bohrungen (69) sind.

12. Gerätekoffer nach Anspruch 2,
dadurch **gekennzeichnet**,
daß als schwingungsdämpfendes Element (60) ein Schwingmetall (61) vorgesehen ist, das aus einem inneren und äußeren Flachstahlelement (62, 63) besteht, die parallel zueinander angeordnet und über eine elastische Einrichtung, insbesondere ein Elastomerstück (65) miteinander verbunden sind.

13. Gerätekoffer nach Anspruch 12,
dadurch **gekennzeichnet**,
daß das Elastomerstück (65) M-förmig ausgebildet ist und daß das äußere Flachstahlelement (63) über Befestigungsbereiche (64, 66) an dem zentralen Schienenteil (55; 59) der Aufnahmeschiene (50; 51) fixierbar ist, während das innere Flachstahlelement (62) am Innenrahmen (30) über Befestigungsöffnungen (41) der Tiefenholme (40) fixierbar ist.

14. Gerätekoffer nach Anspruch 1,
dadurch **gekennzeichnet**,
daß ein die Frontseite (5) oder gegebenenfalls die Rückseite (6) des Gehäusemantels (10) abschließender Deckel (80, 81) eine Deckelplatine (82) und eine umlaufende Dichtkante (84) aufweist.

15. Gerätekoffer nach Anspruch 14,
dadurch **gekennzeichnet**,
daß die Deckelplatine (82) mit Prägungen (86) und Vertiefungen (87) für geschützte Verriegelungen (89), Ventile und Anschlüsse (88) versehen ist und daß als Dichtkante (84) ein Strangpreßprofil (90) an der Dekkelplatine (82) befestigt, insbesondere verschweißt ist.

16. Gerätekoffer nach Anspruch 15,
dadurch **gekennzeichnet**,
daß das Strangpreßprofil (90) des Deckels (80, 81) einen an der Deckelplatine (82) fixierbaren Verbindungssteg (92) mit einer radial nach innen gerichteten T-Nut (94) und einer endseitigen, verstärkt ausgebildeten U-Nut (96) aufweist, deren Schenkel (97, 98) bei geschlossenem Deckel (80, 81) dichtend an der dachförmigen Dichtkante (24) des Hohlprofils (20) des Gehäusemantels (10) anliegen.

## Claims

1. Equipment case with a metallic housing, which has a parallelipipedic housing envelope, as well as a front and a back, at least the front being contructed as a cover, and with an inner frame, which is fixed to and spaced from the housing envelope by vibration-damping elements and which encloses a receiving space for equipments and components,
**characterized** in,
that the housing envelope (10) inculding a bottom surface (12), a top surface (13) and lateral surfaces (14, 15) is made of a single piece metallic flat material (11) and in each case between of the lateral surfaces (14, 15) and the adjacent top surface (13) and bottom surface (12) is formed a corner bevel (16) for vibration-damping reception of the inner frame (30), and that the housing envelope (10) is provided at the front (5) and back (6) with a front (21) and back (22) continous hollow section formed from the single piece flat material (11).

2. Equipment case according to claim 1,
**characterized** in,
that each corner bevel (16) is constructed as a narrow 45° bend of the lateral surfaces (14, 15), top surface (13) and bottom surface (12) of the housing envelope (10), that the front (21) and back (22) hollow section of the housing envelope (10) is formed in the corner bevels (16) by recesses (18) in the flat material (11), which can be welded, and that for fixing the inner frame (30) between the front (21) and back (22) hollow section of the corner bevels (16) in each case there is a reception rail (50) for a vibration-damping element (60) and for the inner frame (30).

3. Equipment case according to claim 2,
**characterized** in,
that the lateral surfaces (14, 15), top surface (13) and bottom surface (12) of the housing envelope (10) to be bent are provided with prefabricated embossings (70) and recessed areas (72) for arranging handles (74), connection elements and elements for transport as well as with closure areas.

4. Equipment case according to claim 2,
**characterized** in,
that the front (21) and back (22) hollow section of the housing envelope (10) is formed by multiple bending of the cut-to-size flat material (11) and in each case is provided with a box section (23) having a roof-like sealing edge (24) directed towards the front (5) and back (6) and diametrically arranged closing edge (26) for cover locking, and that the box section (23) is bent inwards to a support web (27) engaging on the housing envelope (10) and a terminal fastening web (28) projecting almost at right angles to the support web (27), particularly for a sealing element.

5. Equipment case according to claim 1,
**characterized** in,
that the inner frame (30) is formed from front side and back side positioned vertical beams (31, 32; 35, 36) and horizontal beams (33, 34; 37, 38), which have a unitary frame section (75) and are interconnected by depth beams (40).

6. Equipment case according to claim 5,
**characterized** in,
that the frame section (75) of the vertical and horizontal beams (31 to 38) has a frame-web (77) directed towards the housing envelope (10) and having an inner and an outer T-groove (76, 78), the groove-slot (71) of the inner T-groove (76) being directed towards the receiving space (8) and the groove-slot (79) of the outer T-groove (78) towards the front (5) or back (6).

7. Equipment case according to claim 5,
**characterized** in,
that each depth beam (40) comprises two mounting flanges (42, 43) arranged at right angles to one another and whose front (44) and back (45) areas can be fixed to the associated vertical and horizontal beams (31, 35; 33, 37), and that the mounting flanges (42, 43) are interconnected by means of a corner connector (46), the corner connector (46) being located in a 45° bevel and having a projecting front (47) and back (48) cover area for the end faces (39) of the vertical and horizontal beams (31 to 38) of the inner frame (30).

8. Equipment case according to claim 2,
**characterized** in,
that the reception rails (50; 51) fixable in the corner bevels (16) of the housing envelope (10) have two lateral surfaces (52, 53; 54, 56) arranged at right angles to one another and a central rail part (55; 59) constructed in complementary manner to the corner bevels (16) and which are provided with fixing areas (57, 58; 67, 69).

9. Equipment case according to claim 8,
**characterized** in,
that the reception rails (50; 51) are held in the corner bevels (16) of the housing envelope (10) by an adhesive connection.

10. Equipment case according to claim 8,
**characterized** in,
that the fixing areas (57) of the lateral surfaces (52, 53) of a reception rail (50) are elongated holes, and that the central rail part (55) is a rectangular hollow section (55), whose fastening areas (58) are fastening bolts (58).

11. Equipment case according to claim 8,
**characterized** in,
that the fastening areas (67) of the lateral surfaces (54, 56) of a reception rail (51) are formed as a T-groove (67), and that the central rail part (59) has a U-shaped hollow section (59), whose fastening areas (69) are bores (69).

12. Equipment case according to claim 2,
**characterized** in,
that as the the vibration-damping element (60) is provided a vibration mount (61), which comprises an inner and an outer flat steel element (62, 63), which are arranged parallel to one another and are interconnected by means of a resilient means, particularly an elastomer piece (65).

13. Equipment case according to claim 12,
**characterized** in,
that the elastomer piece (65) is M-shaped and that the outer flat steel element (63) can be fixed to the central rail part (55; 59) of the reception rail (50; 51) by means of fastening areas (64; 66), whilst the inner flat steel element (62) can be fixed to the inner frame (30) by means of fastening openings (41) of the depth beams (40).

14. Equipment case according to claim 1,
**characterized** in,
that a cover (80, 81) closing the front (5) or optionally the back (6) of the housing envelope (10) has a cover sheet blank (82) and a continous sealing edge (84).

15. Equipment case according to claim 14,
**characterized** in,
that the cover sheet blank (82) is provided with embossings (86) and depressions (87) for protected locking means (89), valves and connections (88), and that as the sealing edge (84) an extruded section (90) is fixed, particularly welded to the cover sheet blank (82).

16. Equipment case according to claim 15,
**characterized** in,
that the extruded section (90) of the cover (80, 81) has a connecting web (92) fixable to the cover sheet blank (82) with a radially inwardly directed T-groove (94) and a terminal, reinforced U-groove (96), whose legs (97, 98), when the cover (80, 81) is closed, sealingly engage on the roof-shaped sealing edge (24) of the hollow section (20) of the housing envelope (10).

## Revendications

1. Coffre pour appareils avec un boîtier métallique, qui présente une enveloppe de boîtier en forme de parallélépipède rectangle ainsi qu'une face avant et une face arrière, au moins la face avant étant conformée en couvercle, et avec un cadre intérieur, qui est fixé à distance sur l'enveloppe du boîtier par l'intermédiaire d'éléments antivibratoires et enserre une zone de réception pour des instruments et des éléments, ***caractérisée en ce que*** l'enveloppe (10) du boîtier est fabriquée avec une surface de base (12), une surface de couverture (13) et des surfaces latérales (14, 15) dans un matériau plat (11) métallique d'un seul tenant et, à chaque fois, entre les surfaces latérales (14, 15) et la surface de couverture (13) ou de base (12) adjacente, il est formé un biseau d'angle (16) afin de recevoir de manière antivibratoire le cadre intérieur (30), et ***en ce que*** l'enveloppe (10) du boîtier présente, sur la face avant (5) et sur la face arrière (6), un profil creux avant (21) et un profil creux arrière (22) périphériques formés dans le matériau plat d'un seul tenant (11).

2. Coffre pour appareils selon la Revendication 1, ***caractérisée en ce que*** chaque biseau d'angle (16) est réalisé par une étroite pliure à 45° des surfaces latérales (14, 15) de la surface de couverture (13) et de la surface de base (12) de l'enveloppe (10) du boîtier, ***en ce que*** les profils creux avant (21) et arrière (22) de l'enveloppe (10) du boîtier sont formés dans les biseaux d'angle (16) par des évidements soudables (18) réalisés dans le matériau plat (11), et ***en ce que***, pour fixer le cadre intérieur (30) entre les profils creux avant (21) et arrière (22) des biseaux d'angle (16), il est prévu à chaque fois un rail de réception (50) pour recevoir un élément antivibratoire (60) et le cadre intérieur (30).

3. Coffre pour appareils selon la Revendication 2, ***caractérisée en ce que*** les surfaces latérales (14, 15), la surface de couverture (13) et la surface de base (12) de l'enveloppe (10) du boîtier à plier présentent des empreintes (70) préfabriquées et des zones (72) en renfoncement destinées à recevoir des poignées (74), des éléments de liaison et de transport et des zones de fermeture.

4. Coffre pour appareils selon la Revendication 2, ***caractérisée en ce que*** les profils creux avant (21) et arrière (22) de l'enveloppe (10) du boîtier sont formés par des pliures multiples du matériau plat (11) découpé et présentent, à chaque fois, un profil en caisson (23) avec un bord d'étanchéité (24) en forme de toit tourné vers la face avant (5) et vers la face arrière (6) et avec un bord de fermeture (26) en position diamétrale pour un verrouillage de couvercle, et ***en ce que*** le profil en caisson (23) est plié vers l'intérieur pour former une barre d'appui (27) s'appuyant contre l'enveloppe (10) du boîtier et une barre de renfort (28) côté extrémité s'éloignant presque perpendiculairement à la barre d'appui (27), en particulier pour un élément d'étanchéité.

5. Coffre pour appareils selon la Revendication 1, ***caractérisée en ce que*** le cadre intérieur (30) est formé de barres verticales (31, 32 ; 35, 36) et horizontales (33, 34 ; 37, 38) placées à l'avant et à l'arrière, qui présentent un profil de cadre unitaire (75) et sont reliées par des barres de profondeur (40).

6. Coffre pour appareils selon la Revendication 5, ***caractérisée en ce que*** le profil de cadre (75) des barres verticales et des barres horizontales (31 à 38) présente une barre (77) de cadre tournée vers l'enveloppe (10) du boîtier avec une rainure en T intérieure et une rainure en T extérieure (76, 78), la fente (71) de la rainure en T intérieur (76) étant tournée vers la zone de réception (8) et la fente (79) de la rainure en T extérieure (78) étant tournée vers la face avant (5) ou vers la face arrière (6).

7. Coffre pour appareils selon la Revendication 5, ***caractérisée en ce que*** chaque barre de profondeur (40) présente deux brides de fixation (42, 43) placées perpendiculairement l'une à l'autre, dont des parties avant (44) et arrière (45) peuvent se fixer sur les barres verticales et horizontales (31, 35 ; 33, 37) associées, et ***en ce que*** les brides de fixation (42, 43) sont reliées entre elles par un connecteur d'angle (46), le connecteur d'angle (46) étant placé dans un biseau à 45 degrés et présentant une zone de recouvrement avant (47) et une zone de recouvrement arrière (48) pour les surfaces frontales (39) des barres verticales et horizontales (31 à 38) du cadre intérieur (30).

8. Coffre pour appareils selon la Revendication 2, ***caractérisée en ce que*** les rails de réception (50 ; 51) pouvant se fixer dans les biseaux d'angle (16) de l'enveloppe (10) du boîtier présentent deux surfaces latérales (52, 53 ; 54, 56) perpendiculaires l'une à l'autre et une partie de rail centrale (55; 59) formée d'une manière complémentaire aux biseaux d'angle (16), qui sont munies de zones de fixation (57, 58 ; 67, 69).

9. Coffre pour appareils selon la Revendication 8, ***caractérisée en ce que*** les rails de réception (50 ; 51) sont tenus par un assemblage collé dans les biseaux d'angle (16) de l'enveloppe (10) du boîtier.

10. Coffre pour appareils selon la Revendication 8, ***caractérisée en ce que*** les zones de fixation (57) des surfaces latérales (52, 53) d'un rail de réception (50) sont des trous allongés, et ***en ce que*** la partie de rail centrale (55) est un profil creux rectangulaire (55), dont les zones de fixation (58) sont des tourillons (58).

11. Coffre pour appareils selon la Revendication 8, ***caractérisée en ce que*** les zones de fixation (67) des surfaces latérales (54, 56) d'un rail de réception (51) sont conformées en rainure en T (67) et ***en ce que*** la partie de rail centrale (59) est un profil creux en forme de U (59), dont les zones de fixation (69) sont des perçages (69).

12. Coffre pour appareils selon la Revendication 2, ***caractérisée en ce que***, comme élément antivibratoire (60), il est prévu une liaison caoutchouc-métal (61), qui se compose d'éléments en acier plat intérieur et extérieur (62, 63), qui sont disposés parallèlement et sont reliés par un dispositif élastique, en particulier une pièce en élastomère (65).

13. Coffre pour appareils selon la Revendication 12, ***caractérisée en ce que*** la pièce en élastomère (65) est conformée en M, et ***en ce que*** l'élément en acier plat extérieur (63) peut se fixer par l'intermédiaire de zones de fixation (64, 66) à la partie de rail centrale (55 ; 59) du rail de réception (50 ; 51), tandis que l'élément en acier plat intérieur (62) peut se fixer au cadre intérieur (30) par l'intermédiaire d'ouvertures de fixation (41) des barres de profondeur (40).

14. Coffre pour appareils selon la Revendication 1, ***caractérisée en ce qu '***un couvercle (80, 81) enserrant la face avant (5) ou, le cas échéant, la face arrière (6) de l'enveloppe (10) du boîtier présente une platine (82) de couvercle et un bord (84) d'étanchéité périphérique.

15. Coffre pour appareils selon la Revendication 14, ***caractérisée en ce que*** la platine de couvercle (82) est munie d'empreintes (86) et de renfoncements (87) pour des verrouillages protégés (89), des vannes et des raccords (88), et ***en ce que***, comme bord d'étanchéité (84), un profil extrudé (90) est fixé sur la platine (82) de couvercle, en particulier par soudure.

16. Coffre pour appareils selon la Revendication 15, ***caractérisée en ce que*** le profil extrudé (90) du couvercle (80, 81) présente une barre de liaison (92) pouvant se fixer à la platine de couvercle (82) avec une rainure en T (94) tournée vers l'intérieur et une rainure en U (96) côté extrémité, réalisée de manière renforcée, dont les branches (97, 98) s'appuient de manière étanche contre le bord d'étanchéité (24) du profil creux (20) de l'enveloppe (10) du boîtier lorsque le couvercle (80, 81) est fermé.
